(19) Europäisches Patentamt
European Patent Office
Office européen des brevets

(11) EP 3 199 968 A1

(12) EUROPEAN PATENT APPLICATION

(43) Date of publication:
**02.08.2017 Bulletin 2017/31**

(51) Int Cl.:
***G01R 33/565*** *(2006.01)* ***G06T 5/00*** *(2006.01)*
*G01R 33/56* *(2006.01)*

(21) Application number: **16152932.6**

(22) Date of filing: **27.01.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Max-Planck-Gesellschaft zur Förderung der Wissenschaften e.V.
80539 München (DE)**

(72) Inventors:
- **LOKTYUSHIN, Alexander
72076 Tübingen (DE)**
- **SCHEFFLER, Klaus
72076 Tübingen (DE)**
- **EHSES, Philipp
72076 Tübingen (DE)**
- **SCHÖLKOPF, Bernhard
72076 Tübingen (DE)**

(74) Representative: **Bach, Alexander et al
Mitscherlich PartmbB
Patent- und Rechtsanwälte
Sonnenstraße 33
80331 München (DE)**

# (54) AUTOFOCUSING-BASED CORRECTION OF B0 FLUCTUATION-INDUCED GHOSTING

(57) A method for correcting $B_o$ fluctuation-induced ghosting artifacts in long-TE gradient-echo scan images, comprising the steps of
- acquiring an image (u);
- determining phase offsets (Φ);
- applying the phase offsets (Φ) to the image (u);
such that an entropy of the spatial intensity variations in the corrected image (u) decreases.

Fig. 1

autofocusing-based
sequence-based
no phase stabilization
slice 3
slice 6

EP 3 199 968 A1

## Description

The present invention relates to autofocusing-based correction of Bo fluctuation-induced ghosting.

Long-TE gradient-echo images are prone to ghosting artifacts. Such degradation is primarily due to magnetic field variations caused by breathing or motion. The effect of these fluctuations amounts to different phase offsets in each acquired *k*-space line. A common remedy is to measure the problematic phase offsets using an extra non-phase-encoded scan before or after each imaging readout.

It is therefore an object of the present invention to develop a purely data-driven postprocessing method capable of removing Bo fluctuation-induced ghosting artifacts in long-TE gradient-echo scans.

The object is achieved by a method and a system according to the independent claims. Advantageous embodiments are defined in the subclaims. Particularly, the invention estimates the phase offsets directly from the raw image data by optimization-based search of phases that minimize an image quality measure. This eliminates the need for any sequence modifications and additional scan time.

The problem of finding the correct phase offsets is similar to the well-studied autofocusing-based motion correction [1,3], and can be seen as one of its special cases. The optimization problem is formulated and solved where one seeks the latent phase offsets in the Fourier domain that are associated with a minimal value of the image quality measure that is evaluated in the spatial domain. This way, the need for extra non-phase-encoded navigator scans and the related increase in sequence complexity and scan time may be avoided. The experimental results demonstrate that the inventive method is capable of removing the ghosting artifacts, and that the quality of the outcome images is similar to navigator-based reconstructions. To conclude, the proposed method is a valid alternative to using navigators with only a slight increase in post processing time.

These and other aspects of the present invention will be described in more detail in the following detailed description, in relation to the annexed drawing in which

Fig. 1 shows a comparison between uncorrected images with images corrected for Bo fluctuations using a conventional navigator-based approach as well as the proposed autofocusing-based method;

Fig. 2 shows the differences between the autofocusing and navigator-based approaches; and

Fig. 3 shows the differences between the autofocusing and navigator-based approaches.

Equation 1 shows the navigator-less reconstructions formulated as an optimization problem, which involves finding the minimum value of the objective function. The unknown phase values $\Phi$ are searched that are associated with low values of the image quality measure $\varphi$, which is chosen to be the entropy function. More precisely, one computes the entropy of the spatial intensity variations in the SOS-combined image (sum of squares). The matrices that are used to perform the finite difference operations in the ***x*** and ***y*** direction are denoted by $\boldsymbol{G}_x$ and $\boldsymbol{G}_y$, respectively. The phase values $\Phi$ are applied to the acquired images $\mathbf{u}_c$ (for each coil element c) using the diagonal matrix ***A,*** whose elements are the complex exponentials $exp(i\Phi_t)$, with *t* being the repetition index.

$$\hat{\Phi} = \arg\min_{\Phi} \varphi\left(\left(G_x + G_y\right) SOS\left(F^H A_\Phi u_c\right)\right) + \lambda \left\| G\Phi \right\|^2 \qquad (1)$$

In this formulation, the objective function is invariant to circular shifts of the image in the phase-encoding direction because such circular shifts amount to phase ramps (composed of recovered phases $\Phi$) in the frequency domain. The problem of unnecessary circular shifts can be avoided by adding a regularization term which penalizes strong variations of the recovered phases. The parameter X controls the strength of the regularization (it may be set to 0.1).

The resulting non-linear optimization problem may be solved in 80 iterations of the LBFGS[2] algorithm. The operations were implemented from Eq. 1 on the GPU in CUDA, bringing the computation time (for each slice) down to a few seconds.

To evaluate the performance of the proposed method long-TE gradient-echo images were acquired of the brain of a healthy volunteer after obtaining informed consent and approval by the local ethics committee. Data was acquired at 9.4T using a custom-built head coil (16 transmit / 31 receive channels) [4]. 9 slices were acquired of the ventral portions of the brain where field variations are relatively severe, mainly due to breathing-related motion. The GRE sequence included a non-phase-encoded navigator (or phase-stabilization) scan after each imaging readout. The sequence parameters were as follows: TR = 356 ms, TE = 30 ms, nominal flip angle = 45°, matrix = 512x512, resolution = 0.4x0.4 $mm^2$, slice thickness = 1 mm.

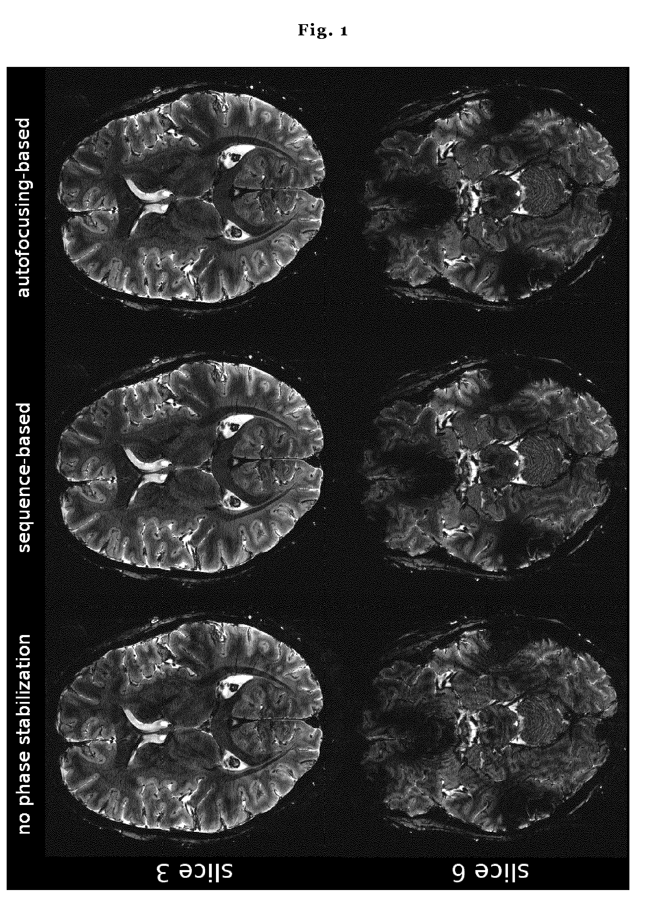

Figure 1 shows a comparison between uncorrected images with images corrected for Bo fluctuations using a conventional navigator-based approach as well as the proposed autofocusing-based method. Ghosting artifacts in the uncorrected data are more severe in slice 6 (shown on the bottom), which is positioned lower than slice 3 (top). In both slices, autofocusing and navigator-based correction techniques are able to significantly improve image quality.

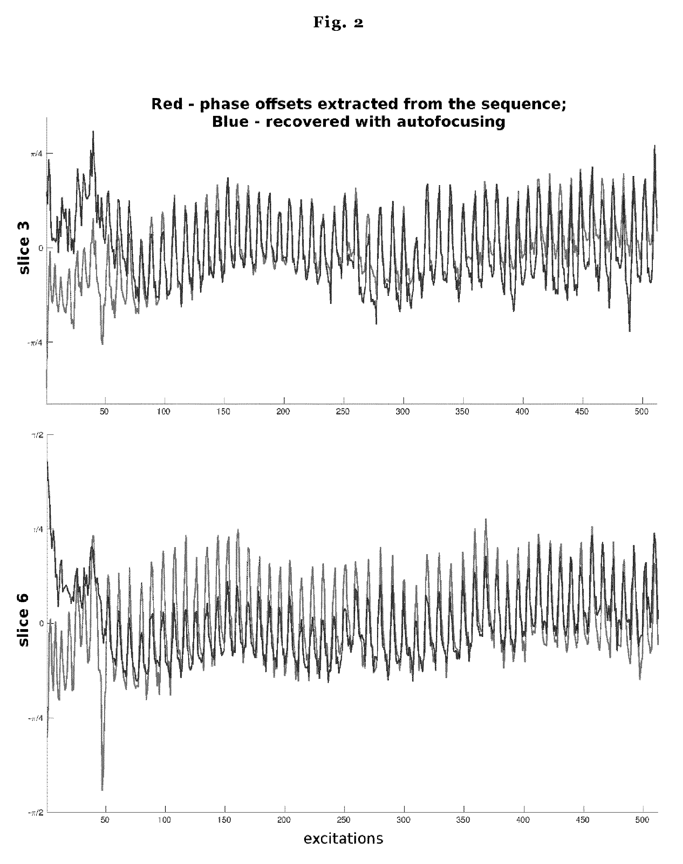

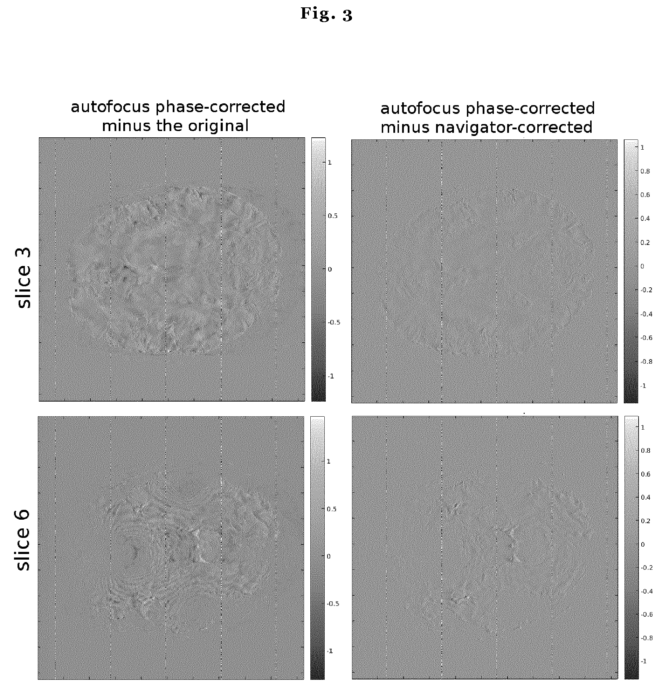

Apart from some flow-related artifacts, ghosting is completely removed and the images resulting from both techniques are practically indistinguishable from one another. In fact, the differences between the autofocusing and navigator-based approaches amount to the minute high-frequency details as illustrated in Figure 2. Figure 3 compares the phase offsets retrieved by our autofocusing algorithm with the navigator-based measurement.

Since there is a sign as well as a global phase offset ambiguity, the sign was adjusted and the mean was subtracted from both phase series before plotting them. Although there are a few differences in the recovered phase values, the general pattern of oscillations (caused by breathing) is the same.

## Claims

**1.** Method for correcting $B_o$ fluctuation-induced ghosting artifacts in long-TE gradient-echo scan images, comprising the steps of

- acquiring an image (u);
- determining phase offsets ($\Phi$);
- applying the phase offsets ($\Phi$) to the image (u);

such that an entropy of the spatial intensity variations in the corrected image (u) decreases.

**2.** The method of claim 1, wherein the phase offsets are determined using the LBFGS algorithm.

**3.** The method of claim 1, implemented on a GPU in CUDA.

**4.** The method of claim 1, wherein $B_o$ = 9,4 Tesla.

**5.** The method of claim 1, wherein a regularization term is added for penalizing strong variations of the recovered phases.

**6.** Device for correcting $B_o$ fluctuation-induced ghosting artifacts in long-TE gradient-echo scan images, comprising:

- an image acquisition unit for acquiring an image (u);
- a phase offset determining unit for determining phase offsets ($\Phi$);
- a phase offset applying unit for applying the phase offsets ($\Phi$) to the image (u);

such that an entropy of the spatial intensity variations in the corrected image (u) decreases.

**Fig. 1**

autofocusing-based
sequence-based
no phase stabilization
slice 3
slice 6

Fig. 2

Red - phase offsets extracted from the sequence;
Blue - recovered with autofocusing
slice 3
π/4
0
-π/4
50
100
150
200
250
300
350
400
450
500
slice 6
π/2
π/4
0
-π/4
-π/2
50
100
150
200
250
300
350
400
450
500
excitations

Fig. 3

autofocus phase-corrected
minus the original
autofocus phase-corrected
minus navigator-corrected
slice 3
slice 6
1
0.5
0
-0.5
-1
1
0.8
0.6
0.4
0.2
0
-0.2
-0.4
-0.6
-0.8
-1

Europäisches Patentamt
European Patent Office
Office européen des brevets

# EUROPEAN SEARCH REPORT

Application Number
EP 16 15 2932

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 728 757 B2 (CHO KWANG M [US]) 1 June 2010 (2010-06-01) * column 2, line 31 - line 57 * * column 4, line 23 - line 35 * * column 6, line 10 - column 7, line 21 * * column 8, line 60 - column 11, line 49; claim 1 * ----- | 6 | INV. G01R33/565 G06T5/00 ADD. G01R33/56 |
| X | BROCKSTEDT SARA ET AL: "High-resolution diffusion imaging using phase-corrected segmented echo-planer imaging", MAGNETIC RESONANCE IMAGING, ELSEVIER SCIENCE, TARRYTOWN, NY, US, vol. 18, no. 6, 1 January 2000 (2000-01-01), pages 649-657, XP002967687, ISSN: 0730-725X, DOI: 10.1016/S0730-725X(00)00159-4 * sections 1, 2.2 and 4 * ----- | 1,3,4 | |
| A | ALEXANDER LOKTYUSHIN ET AL: "Blind retrospective motion correction of MR images", MAGNETIC RESONANCE IN MEDICINE., vol. 70, no. 6, 11 February 2013 (2013-02-11), pages 1608-1618, XP055288829, US ISSN: 0740-3194, DOI: 10.1002/mrm.24615 * the whole document * ----- -/-- | 1-6 | TECHNICAL FIELDS SEARCHED (IPC) G01R G06T |

The present search report has been drawn up for all claims

2

| Place of search | Date of completion of the search | Examiner |
|---|---|---|
| Munich | 18 July 2016 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt
European
Patent Office
Office européen
des brevets

# EUROPEAN SEARCH REPORT

Application Number
EP 16 15 2932

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MCGEE K P ET AL: "Image metric-based correction (autocorrection) of motion effects: analysis of image metrics", JOURNAL OF MAGNETIC RESONANCE IMAGING, SOCIETY FOR MAGNETIC RESONANCE IMAGING, OAK BROOK, IL, US, vol. 11, no. 2, 1 February 2000 (2000-02-01), pages 174-181, XP002276109, ISSN: 1053-1807, DOI: 10.1002/(SICI)1522-2586(200002)11:2<174::AID-JMRI15>3.0.CO;2-3 * the whole document * ----- | 1-6 | |
| A | LIN W ET AL: "Improved optimization strategies for autofocusing motion compensation in MRI via the analysis of image metric maps", MAGNETIC RESONANCE IMAGING, ELSEVIER SCIENCE, TARRYTOWN, NY, US, vol. 24, no. 6, 1 July 2006 (2006-07-01), pages 751-760, XP028004862, ISSN: 0730-725X, DOI: 10.1016/J.MRI.2006.02.003 [retrieved on 2006-07-01] * the whole document * ----- | 1-6 | TECHNICAL FIELDS SEARCHED (IPC) |
| A | DAVID ATKINSON ET AL: "Automatic Correction of Motion Artifacts in Magnetic Resonance Images Using an Entropy Focus Criterion", IEEE TRANSACTIONS ON MEDICAL IMAGING, IEEE SERVICE CENTER, PISCATAWAY, NJ, US, vol. 16, no. 6, 1 December 1997 (1997-12-01), XP011035675, ISSN: 0278-0062 * the whole document * ----- | 1-6 | |

The present search report has been drawn up for all claims

2

| Place of search | Date of completion of the search | Examiner |
|---|---|---|
| Munich | 18 July 2016 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO. EP 16 15 2932

This annex lists the patent family members relating to the patent documents cited in the above-mentioned European search report. The members are as contained in the European Patent Office EDP file on The European Patent Office is in no way liable for these particulars which are merely given for the purpose of information.

18-07-2016

| Patent document cited in search report | Publication date | Patent family member(s) | Publication date |
|---|---|---|---|
| US 7728757 B2 | 01-06-2010 | GB 2460755 A | 16-12-2009 |
| | | US 2009303111 A1 | 10-12-2009 |

EPO FORM P0459

For more details about this annex : see Official Journal of the European Patent Office, No. 12/82